(19)

Europäisches
Patentamt
European
Patent Office
Office européen
des brevets

(11) **EP 4 645 313 A1**

(12) **EUROPEAN PATENT APPLICATION**

(43) Date of publication:
05.11.2025 Bulletin 2025/45

(21) Application number: 24183088.4

(22) Date of filing: 19.06.2024

(51) International Patent Classification (IPC):
*G11C 5/02* (2006.01)   *G11C 5/06* (2006.01)
*G11C 7/22* (2006.01)   *G11C 11/417* (2006.01)

(52) Cooperative Patent Classification (CPC):
**G11C 5/025; G11C 5/063; G11C 7/222;**
G11C 11/417; G11C 2207/2272

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 02.05.2024 IN 202441034944

(71) Applicant: NXP B.V.
5656 AG Eindhoven (NL)

(72) Inventors:
• Singh, Jainendra
5656AG Eindhoven (NL)

• Mishra, Jwalant Kumar
5656AG Eindhoven (NL)
• Kohli, Rajat
5656AG Eindhoven (NL)
• Singh, Shakti
5656AG Eindhoven (NL)
• C S, Madhukar
5656AG Eindhoven (NL)

(74) Representative: Hardingham, Christopher Mark
NXP Semiconductors
Intellectual Property Group
The Cattle Barn
Upper Ashfield Farm, Hoe Lane
Romsey, Hampshire S051 9NJ (GB)

(54) **MEMORY AND METHOD FOR CONSTRUCTING A MEMORY**

(57) A memory (300) comprises a multi stage clock-partitioning circuit, and at least one upper bitcell memory array (350, 352) and at least one lower bitcell memory array (354, 356). An input is configured to receive an external clock signal. A first stage (210) of the multi stage clock-partitioning circuit is configured to receive the external clock signal and generate a first internal clock signal and provide the first internal clock signal to the bitcell memory arrays. A second stage (220) of the multi stage clock-partitioning circuit is configured to receive the first internal clock signal and generate a second internal clock signal. A third stage (230) of the multi stage clock-partitioning circuit is configured to receive the second internal clock signal and generate a third word line generated clock signal and provide the third internal clock signal to the at least upper and lower bitcell memory arrays.

FIG. 3

**Description**

Technical Field

The technical field relates to a memory and a method for constructing a memory with improved internal clock timing and power consumption. The technical field is applicable to, but not limited to, an arrangement of clock partitioning to reduce resistance and capacitance by placement of a clock buffer.

Background of the invention

It is known that a bit cell, or a bitcell, is the basic building block of a memory array, and in turn, of a memory chip. Each cell comprises a small circuit with a memory element and a selector. The memory element stores data (either a logic '1' or a logic '0') and the selector activates the cell when accessed.

It is known that typical static random access memory (SRAM) / read only memory (ROM) use such bitcell memory arrays and they employ techniques for routing and using clock signals for accessing (reading from or writing to) the memory elements. In order to improve access to the memory, it is known that buffers are inserted into clock paths, often implemented to optimize and reduce resistance-capacitance (RC) delay. However, the use of buffers in memory increases the silicon area and gate delay of the memory. The insertion of such logic buffers in memory increases the gate delay as each logic buffer imparts some propagation delay of the clock signal. Furthermore, as more input gate capacitance and metal capacitance is introduced, the effect of these will directly increase the toggle power.

It is also known that typical SRAMs / ROMs use a two-stage clock partitioning scheme, whereby a first clock stage is driven by metal load, and a second stage is driven by a gate load. Here, bank clock decoding is used to select a top bank of memory or a bottom bank of memory, where a memory internal clock is the input signal. A memory 'address' signal is used to decode, at a memory bank level and memory row level and select between the top bank and bottom bank of the memory. In known memories, bank clock decoding generates another internal clock that is used as an input signal for word line decoding. Word line decoding is used to generate the word line to select a particular row of the memory. For word line decoding, a first input will be the internal clock that is generated using the bank clock decoding and a second input is the decoded address that us provided by pre decoders. However, this arrangement causes an increase in consumed clock toggle power. A first memory 100 is shown with a SRAM 6T bit cell array 110 that is used to store data. The first memory 100 includes a column multiplexer function 115 that is configured to select a particular bit cell to perform a write/read operation. The first memory 100 and second memory 150 include memory areas dedicated for 2-stage word-line decoding 120 and 1-stage bank clock decoding 130. The first memory 100 is shown having a write driver and charge pump circuit 125 that is configured to provide a negative boost to the bit line of bit cell and an input/output cell 135 configured to provide the input to and take the output from memory. A clock pin 140 is provided to both memories to provide the memories with a system clock.

It is known that access-time optimization is challenging in lower technology nodes, which typically refers to smaller channel length of transistorthat are below 28nm. RC delays are also becoming large generally as a result of both resistance and capacitance increases. The cross section of the metal in the memory and metal run length is becoming smaller, and hence resistance is increasing. Also, these developments cause a reduction in capacitance gate oxide thickness, and hence capacitance is increasing, which leads to very large access time. Furthermore, gate load is becoming larger as gate oxide thickness is reduced, as compared to higher technology nodes, as exemplified with the known capacitance formula

$$C = \varepsilon A/d \qquad [1]$$

where the capacitance is denoted by (C), $\varepsilon$ is the permittivity of the dielectric material, A is the area of one of the plates, and d is the distance between the plates (i.e., thickness of oxide).

Hence, toggling the capacitance is leading to increase in signal toggle power. Each gate of transistor will have a gate capacitance load and that gate will be connecting as an input to the other device and hence toggling the input of that gate device will also toggle the gate capacitance load of that device, typically referred to as toggling capacitance. As a consequence, toggling capacitance leads to increased toggle power, as capacitance load is directly connecting to the energy consumptions which is $E = (1/2)CV^2$ , hence if capacitance will increase that means it will also lead to increase the toggle power.

The inventors have recognised and appreciated the following influences that affect memory access time. Access time and clock power are identified as key optimization parameters of a memory. Internal clock distribution is one of the main contributor of access time. Clock toggle power during an active operation in memory is constant for given word-size which has been identified by the inventors as a significant percentage of overall SRAM power consumption.

Accordingly, there is a need for a memory and method for reducing memory access time.

Summary of the invention

The present invention provides a memory and method for constructing a memory architecture, as described in the accompanying claims. Specific embodiments of the invention are set forth in the dependent claims. These and other aspects of the invention will be apparent from and elucidated with reference to the embodiments described hereinafter.

According to a first aspect, there is provided a memory that comprises a multi stage clock-partitioning circuit, and at least one upper bitcell memory array and at least one lower bitcell memory array. An input is configured to receive an external clock signal. A first stage of the multi stage clock-partitioning circuit is configured to receive the external clock signal and generate a first internal clock signal and provide the first internal clock signal to the bitcell memory arrays. A second stage of the multi stage clock-partitioning circuit is configured to receive the first internal clock signal and generate a second internal clock signal. A third stage of the multi stage clock-partitioning circuit is configured to receive the second internal clock signal and generate a third word line generated clock signal and provide the third word line generated clock signal to the at least upper and lower bitcell memory arrays. In this manner, the inventors recognised and appreciated that partitioning a memory clock into at least three segments that divides and distributes the gate capacitance load and the clock signals' line metal capacitance load improves memory access time and reduces memory power consumption whilst reducing required silicon area of the memory.

In some examples, the memory comprises a central portion that includes the multi stage clock-partitioning circuit and wherein the at least one upper bitcell memory array and the at least one lower bitcell memory array each comprise a bitcell memory array located on a first (illustrated right) side of the memory and located on a second (illustrated left) side of the memory, substantially in a quadrant design. In some example embodiments, the memory further comprises at least two first internal clock buffer circuits located in the central portion, wherein a first first internal clock buffer circuit may be located adjacent the upper bitcell memory array and a second first internal clock buffer circuit may be located adjacent the lower bitcell memory array. In some example embodiments, the first first internal clock buffer circuit and the second first internal clock buffer circuit are located equidistant from the input. In this manner, the clock signal being buffered by each of the first internal clock buffer circuits may be substantially the same (i.e., has the same clock phase and clock transitions).

In some examples, the memory further comprises at least four second internal clock generation circuits located in the central portion, wherein a first second internal clock generation circuit may be located adjacent an upper portion of the upper bitcell memory array, a second second internal clock generation circuit may be located adjacent a lower portion of the upper bitcell memory array, a third second internal clock generation circuit may be located adjacent an upper portion of the lower bitcell memory array and a fourth second internal clock generation circuits may be located adjacent a lower portion of the lower bitcell memory array. In some example embodiments, the first second internal clock generation circuit and the fourth second internal clock generation circuit are located equidistant from the input; and the second second internal clock generation circuit and the third second internal clock generation circuit are also located equidistant from the input. Again, in this manner, the clock signal being generated by each of the second internal clock generation circuits may be substantially the same (i.e., has the same clock phase and clock transitions).

In some example embodiments, the memory may further comprise at least eight third internal clock generation circuits located in the central portion, wherein a first third internal clock generation circuit (330) may be located adjacent an upper, upper portion of the upper bitcell memory array, a second third internal clock generation circuit may be located adjacent a lower, upper portion of the upper bitcell memory array, a third third internal clock generation circuit may be located adjacent an upper, lower portion of the upper bitcell memory array, and a fourth third internal clock generation circuit may be located adjacent a lower, lower portion of the upper bitcell memory array. Similarly, a fifth third internal clock generation circuit may be located adjacent an upper, upper portion of the lower bitcell memory array, a sixth third internal clock generation circuit may be located adjacent a lower, upper portion of the lower bitcell memory array, a seventh third internal clock generation circuit may be located adjacent an upper, lower portion of the lower bitcell memory array, and an eighth third internal clock generation circuit may be located adjacent a lower, lower portion of the lower bitcell memory array. In some example embodiments, the first third internal clock generation circuit and the eighth third internal clock generation circuit may be located equidistant from the input; the second third internal clock generation circuit and the seventh third internal clock generation circuit may be located equidistant from the input; the third third internal clock generation circuit and the sixth third internal clock generation circuit may be located equidistant from the input; and the fourth third internal clock generation circuit and the fifth third internal clock generation circuit may be located equidistant from the input.

In some example embodiments, the first stage of the memory may comprise a memory selection circuit, the second stage may comprise a memory bank clock decoding circuit and the third stage may comprise a word line decoding circuit. The memory may be a static random access memory, SRAM, or a read only memory, ROM.

According to a second aspect, there is provided a method of constructing a memory comprising a multi stage clock-partitioning circuit, the memory comprising at least at least one upper bitcell memory array and at least one lower bitcell memory array. The method comprises: receiving an external clock signal; generating in a first stage of the multi stage clock-partitioning circuit, a first internal clock signal from the external clock signal and providing the first internal clock signal to the upper bitcell memory array and the lower bitcell memory array. The method comprises generating, in a second stage of the multi stage clock-partitioning circuit, a second internal clock signal from the first internal clock signal; generating, in a third stage of the multi stage clock-partitioning circuit, a third word line generated clock signal from the second internal clock signal; and providing the third word line generated clock signal to the at least one upper bitcell memory array and the at least one lower bitcell memory array.

Brief description of the drawings

Further details, aspects and embodiments of the invention will be described, by way of example only, with reference to the drawings. In the drawings, like reference numbers are used to identify like or functionally similar elements. Elements in the figures are illustrated for simplicity and clarity and have not necessarily been drawn to scale.

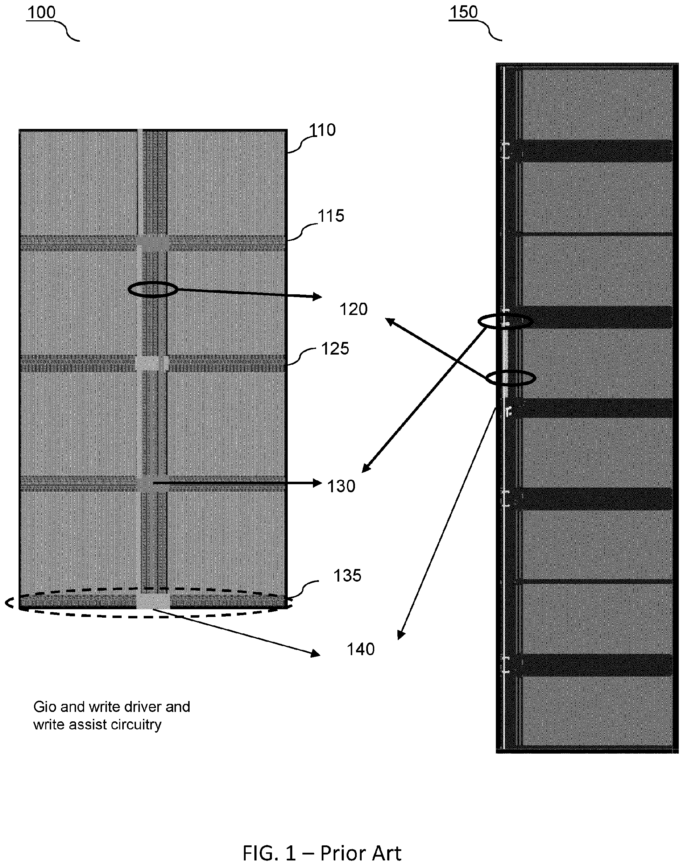

FIG. 1 illustrates two simplified known representations of a memory architecture.

FIG. 2 illustrates a simplified representation of a multi-stage memory partitioning scheme with improved internal clock circuitry placement, according to example embodiments.

FIG. 3 illustrates a more detailed representation of a three-stage memory partitioning scheme with word line and clock generation, according to example embodiments.

FIG. 4 illustrates a representation of a multi-stage memory partitioning scheme beyond a three-stage memory partitioning scheme, according to example embodiments.

FIG. 5 illustrates a simplified timing diagram of a clock generation in a three-stage memory partitioning scheme, according to example embodiments.

FIG. 6 illustrates a simplified comparison of clock generation in a multi-stage memory partitioning scheme versus a known two-stage scheme and a clock buffering scheme.

FIG. 7 illustrates a simplified flowchart of a method of clock generation in a multi-stage memory partitioning scheme, according to example embodiments.

Detailed description

The inventors recognised and appreciated that a memory's internal clock delay directly contributes to the memory access time. In contrast to known memory architectures, examples herein described partition the internal clock circuitry into multi-stages (i.e., more than two stages/segments) and in some illustrated examples partitioning the internal clock circuitry and clock signal paths into three segments, in order to optimize the internal clock capacitance load. The inventors recognised and appreciated that partitioning a memory clock into at least three segments divides and distributes the gate capacitance load and the clock signals' line metal capacitance load. Hence, in a three-segment approach illustrated in more detail below, the memory includes a reduced resistance-capacitance (RC) delay, and therefore a memory's internal clock delay is reduced, as well as achieving a reduced toggling capacitance of the clock signal lines. In this manner, the memory access time is improved/optimized, without an associated increase of metal layer and silicon area. Thus, clock dynamic power may be reduced in, say, a SRAM.

In addition, the partitioning of the internal clock circuitry and clock signal paths into, say, three segments further comprises an optimal placement/location of the internal clock circuitry and clock signal paths, which a skilled artisan readily appreciates is a complex implementation challenge.

The following detailed description is merely illustrative in nature and is not intended to limit the embodiments of the subject matter or the application and uses of such embodiments. As used herein, the word "example" means "serving as an example, instance, or illustration." Any implementation described herein as an example is not necessarily to be construed as preferred or advantageous over other implementations.

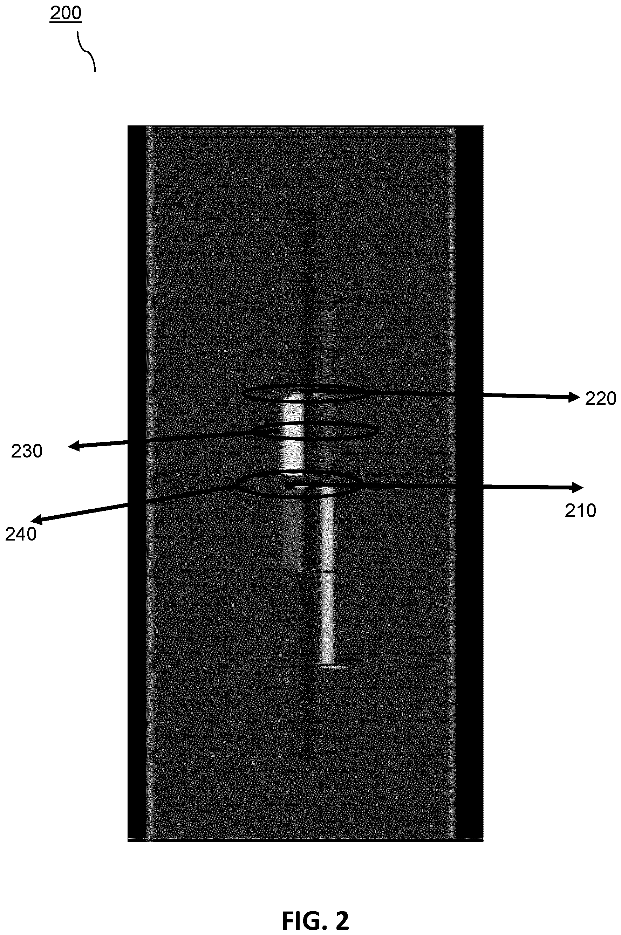

Referring now to FIG. 2, a simplified representation of a multi-stage memory partitioning scheme 200 with improved internal clock circuitry placement, is illustrated, according to example embodiments. The multi-stage memory partitioning scheme 200, illustrates a first-internal clock signalt 210, a second internal clock signal 220 and a word-line generation using the second internal clock 230.

As illustrated, an external clock 240 is applied at the center of the SRAM, which is used to generate further internal clocks in a distributed clock path partitioning scheme that are routed to the upper half and lower half of the memory.

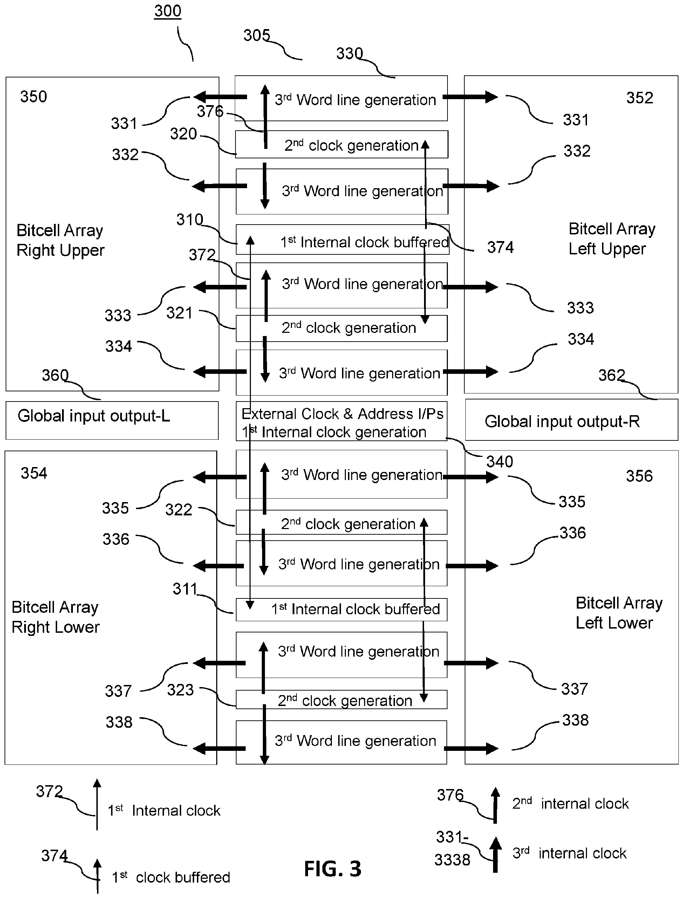

Referring now to FIG. 3, a more detailed representation of a multi-stage memory partitioning scheme 300, with word line and clock generation, is illustrated according to example embodiments. In particular, FIG. 3 illustrates and describes the multi-stage memory in greater detail, in particular where the first stage comprises a memory selection circuit, the second stage comprises the memory bank clock decoding circuit and the third stage comprises the word line decoding circuit.

The multi-stage memory partitioning scheme 300 includes four equal bitcell arrays of memory, a first (illustrated right) upper bitcell memory array 350, a second (illustrated left) upper bitcell memory array 352, a third (illustrated right) lower bitcell memory array 354 and a fourth (illustrated left) lower bitcell memory array 356. In some examples, it is important for the upper half bitcell memory arrays 350, 352 and lower half bitcell memory arrays 354, 356 to be substantially (or exactly) half, as it affects the capacitance load and any mis-match of the equal portions will affect the RC delay between the two halves and affect the access time and power calculations.

As illustrated, the multi-stage memory partitioning scheme 300 comprises an external clock being input to the central portion 340 of the memory. Circuitry is included in the central portion 340 of the memory to generate a first internal clock 372 for the upper bitcell array 350, 352. The central portion 340 of the memory also receives address inputs. In the illustrated multi-stage memory partitioning scheme 300, a second (illustrated left)-hand portion of the memory is included to provide a first global input-output memory access 360 and a first (illustrated right)-hand portion of the memory is included to provide a second global input-output memory access 362. The global input output memory access 360 on the left side and global input output memory access 362 on the right side are used to give provide input data and provide access to the output data of the memory. Also shown are features 373, 375 and 377, these are first internal clock, first buffered clock and second internal clock for the lower bitcell array of the memory 300 . Also show are first buffered clock 374 and second internal clock 376 for the upper bitcell array of the memory 300. Based on the memory selection, of either upper bitcell array of the memory 200 or lower bitcell array of the memory 300, the first internal clock 372, 3737 is generated and the second internal clock 376, 377 generates a word line.

As illustrated, the multi-stage memory partitioning scheme 300 includes a first buffering circuit 310 in a central portion 305 of the memory located between the first (illustrated right) upper bitcell memory array 350 and the second (illustrated left) upper bitcell memory array 352, and a second buffering circuit 311 located between the third (illustrated left) lower bitcell memory array 354 and the fourth (illustrated left) lower bitcell memory array 356. {

In this manner, the first internal clock buffering circuit 310 and the second internal clock buffering circuit 311 are configured to receive and buffer the first internal clock 372 received from the central portion 340 of the memory. The first internal clock buffering circuit 310 is configured to provide the buffered first internal clock 374 to respective second clock generation circuits 320, 321 (also located in the central portion 305 of the memory and located equidistant from the first buffering circuit 310) in the upper half of the memory. The second internal clock buffering circuit 311 is configured to provide the buffered first internal clock 374 to respective second clock generation circuits 322, 323 (also located in the central portion 305 of the memory and located equidistant from the second buffering circuit 311) in the lower half of the memory.

As illustrated, the multi-stage memory partitioning scheme 300 also includes a number of third-stage word line generation circuits in a central portion 305 of the memory located between the first (illustrated right) upper bitcell memory array 350 and the second (illustrated left) upper bitcell memory array 352, and between the third (illustrated right) lower bitcell memory array 354 and the fourth (illustrated left) lower bitcell memory array 356. The third-stage word line generation circuits are located either side of the respective second-stage clock generation circuits 320, 321, 322 and 323 and arranged to receive the second internal clock signals 376 therefrom.

In particular, a (first) third-stage word line generation circuit is located in the central portion 305 of the memory above second-stage clock generation circuit 320 and generates a third-stage word line clock signal 332, and a (second) third-stage word line generation circuit is located in the central portion 305 of the memory below second-stage clock generation circuit 321 and generates a third-stage word line clock signal 332. A (third) third-stage word line generation circuit is located in the central portion 305 of the memory above second-stage clock generation circuit 321 and generates a third-stage word line clock signal 333, and a (fourth) third-stage word line generation circuit is located in the central portion 305 of the memory below second-stage clock generation circuit 321 and generates a third-stage word line clock signal 334. A (fifth) third-stage word line generation circuit is located in the central portion 305 of the memory above second-stage clock generation circuit 322 and generates a third-stage word line clock signal 322, and a (sixth) third-stage word line generation circuit is located in the central portion 305 of the memory below second-stage clock generation circuit 322 and generates a third-stage word line clock signal 336. A (fourth) third-stage word line generation circuit is located in the central portion 305 of the memory above second-stage clock generation circuit 323 and generates a third-stage word line clock signal 337, and a (eighth) third-stage word line generation circuit is located in the central portion 305 of the memory below second-stage clock generation circuit 323 and generates a third-stage word line clock signal 338. In this manner, each of the first (illustrated right) upper bitcell memory array 350, the second (illustrated left) upper bitcell memory array 352, the third (illustrated right) lower bitcell memory array 354 and the fourth (illustrated left) lower bitcell memory array 356 are configured to receive a time-aligned second-stage clock from a respective second-stage clock generation circuit and output a time-aligned third-stage word line internal clock to a bitcell memory array, due to the symmetric and equidistant nature of the memory circuits

In clock partitioning in the first stage, the external clock input to the central portion 340 of the memory is used to generate the internal clocks and transfer information at clock partitioning, i.e., when the clock is transitioning from the first stage to the second stage ... and then the second stage to the third stage. Thus, at the first stage, the external clock is configured to generate the internal clocks, which are used to select either the upper half of the memory or the lower half of the memory whilst travelling to the middle of the each upper half of the memory or lower half of the memory. In the middle of each half of the memory, the first internal clock 372 is buffered by buffering circuits 310, 311 and used to boost the internal clock. This generated internal clock is routed to the second stage as an input to the upper half of the rows and lower half of the row of the memory architecture 300.

In the third stage of the clock partitioning, the internal clock (i.e., the second internal clock 376 received from the second clock generation circuit(s) 322 is used to generate a third stage internal word line clock 331, 332, 333, 334, 335, 336, 337, 338, and word line will be used to access the bitcells for read or write information.

In this manner, the use of a multi-stage clock partitioning scheme, and in this example employing a three -stage approach, creates a gate load dominant arrangement that is approximately 60af/fin, thereby reducing the RC delay compared to the known two-stage designs. In some examples, with the proposed multi-stage clock partitioning scheme, up to 100fF capacitance load is reduced thereby the memory architecture directly gains in terms of clock toggle power, e.g., -26% for an 8kx64 memory.

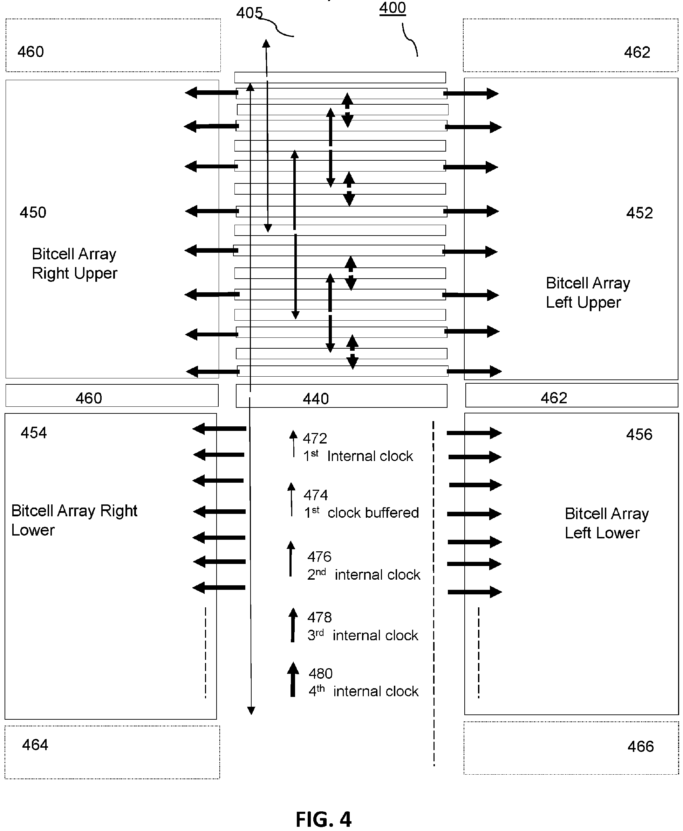

Referring now to FIG. 4, a representation of a multi-stage memory partitioning scheme 400 beyond a three-stage memory partitioning scheme is illustrated, according to example embodiments. As illustrated, compared to the example in FIG. 3, the bitcell memory arrays 350, 352, 354, 356 may be extended 450, 452, 454, 456 and/or include yet further bitcell memory arrays 460, 462, 464, 466. A skilled artisan will recognise and appreciate how the multi-stage memory partitioning scheme 400 can be extended in FIG. 4, with the circuit/logic functions not being described in detail for ease of explanation. Here, a first internal clock signal 472 is generated from an external input at 440, located centrally to the multi-stage memory. At a first internal clock buffering stage, the first internal clock signal 472 is buffered and distributed evenly (and equidistant from the first internal clock buffering stage) to a second internal clock generation stage. Here, multiple second internal clock signals 476 are generated and again distributed evenly (and equidistant from the second internal clock generation stage) to a third internal clock generation stage. Here, multiple third word line generated clock signals 478 are generated and again distributed evenly (and equidistant from the third internal clock generation stage) to a fourth internal clock generation stage. Multiple fourth internal clock signals 480 are generated in the fourth internal clock generation stage and fourth word line generation signals are input evenly int the respective bitcell memory arrays 450, 452, 454, 456.

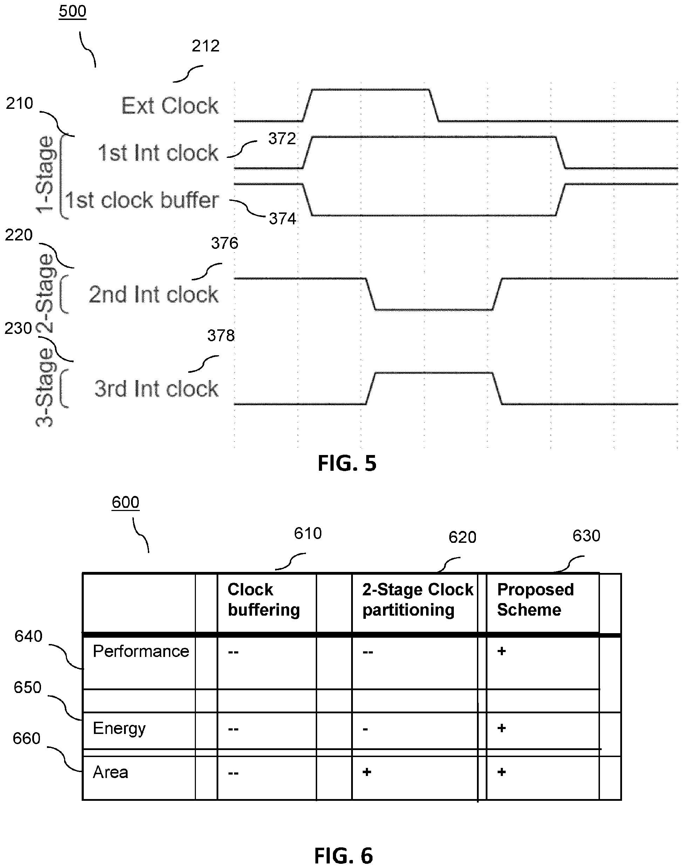

Referring now to FIG. 5, a simplified timing diagram of a clock generation in a multi-stage clock-partitioning scheme 500 is illustrated, which in this example is a three-stage memory partitioning scheme, according to example embodiments. In this three-stage memory partitioning scheme, a first stage 210, a second stage 220 and a third stage 230 are illustrated. An external clock signal 212 is input and in the first stage 210, a first internal clock 372 is generated from the external clock signal 212, which in this example is a reduction in clock speed by half. The first internal clock 372 is then buffered and inverted to create a first internal buffered clock 374. In the second stage 220, in this example, a second internal clock 376 is then generated from the first internal buffered clock 374, which in this example is a version of the first internal buffered clock 374 delayed by ¼ of a clock period. This second stage 220 causes a metal load dominant scenario, which is approximately 200af/um. In the third stage 230, in this example, a third internal clock 378 is then generated from the second internal clock 376 which in this example is an inverted second internal clock 376. Although the timing diagram shows a particular first example arrangement for generating respective internal clocks using a variety of buffering, delaying and inverting of received clock signals, it is envisaged that many other variations and order of creating clock signals and intermediate clock signals could be employed, as will be readily appreciated by a skilled artisan.

Referring now to FIG. 6, a simplified comparison table 600 of clock generation in a multi-stage memory partitioning scheme 630 versus a known two-stage scheme 620 and a clock buffering scheme 610 is illustrated. The comparisons are shown for performance 640, energy usage 650 and silicon area requirements 660. As illustrated, it has been shown that the herein described multi-stage memory partitioning scheme 630 and the known two-stage scheme 620 outperform the clock buffering scheme 610 with regard to their respective silicon area requirements 660. Notably, the multi-stage memory partitioning scheme 630 additionally outperforms the known two-stage scheme 620 and the clock buffering scheme 610 with regard to both its performance 640 and energy usage 650.

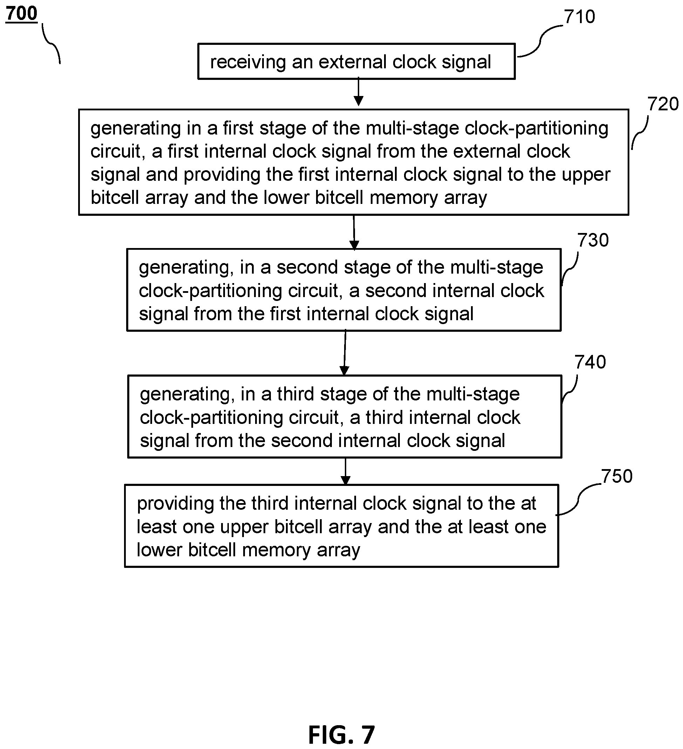

Referring now to FIG. 7, a simplified flowchart 700 of constructing a memory comprising a multi stage clock-partitioning circuit is illustrated, for example the multi-stage clock-partitioning circuit 300 in FIG. 3, according to example embodiments. The memory comprises at least one upper bitcell memory array 350, 352 and at least one lower bitcell memory array 354, 356. The simplified flowchart 700 comprises, at 710 receiving an external clock signal; and at 720 generating in a first stage of the multi stage clock-partitioning circuit, a first internal clock signal from the external clock signal and providing the first internal clock signal to the upper bitcell memory array 350, 352 and the lower bitcell memory array 354, 356. At 730, the simplified flowchart 700 comprises generating, in a second stage of the multi stage clock-partitioning circuit, a second internal clock signal from the first internal clock signal and at 740 generating, in a third stage of the multi stage clock-partitioning circuit, a third word line generated clock signal from the second internal clock signal. At 750, the simplified flowchart 700 comprises providing the third word line generated clock signal to the at least one upper bitcell memory array 350, 352 and the at least one lower bitcell memory array 354, 356.

It is envisaged that the concepts herein described are suited for all memories, particularly those that benefit from improved access. Of course, the method can also be applied to other memory applications.

In the foregoing specification, the invention has been described with reference to specific examples of embodiments of the invention. It will, however, be evident that various modifications and changes may be made therein without departing from the scope of the invention as set forth in the appended claims and that the claims are not limited to the specific examples described above.

The connections as discussed herein may be any type of connection suitable to transfer signals from or to the respective nodes, units or devices, for example via intermediate devices. Accordingly, unless implied or stated otherwise, the connections may for example be direct connections or indirect connections. The connections may be illustrated or described in reference to being a single connection, a plurality of connections, unidirectional connections, or bidirectional connections. However, different embodiments may vary the implementation of the connections. For example, separate unidirectional connections may be used rather than bidirectional connections and vice versa. Also, plurality of connections may be replaced with a single connection that transfers multiple signals serially or in a time multiplexed manner. Likewise, single connections carrying multiple signals may be separated out into various different connections carrying subsets of these signals. Therefore, many options exist for transferring signals. Those skilled in the art will recognize that the architectures depicted herein are merely exemplary, and that in fact many other architectures can be implemented which achieve the same functionality.

Any arrangement of components to achieve the same functionality is effectively 'associated' such that the desired functionality is achieved. Hence, any two components herein combined to achieve a particular functionality can be seen as 'associated with' each other such that the desired functionality is achieved, irrespective of architectures or intermediary components. Likewise, any two components so associated can also be viewed as being 'operably connected,' or 'operably coupled,' to each other to achieve the desired functionality.

Furthermore, those skilled in the art will recognize that boundaries between the above-described operations merely illustrative. The multiple operations may be combined into a single operation, a single operation may be distributed in additional operations and operations may be executed at least partially overlapping in time. Moreover, alternative embodiments may include multiple instances of a particular operation, and the order of operations may be altered in various other embodiments. Also, for example in one embodiment, the illustrated examples may be implemented as circuitry located on a single integrated circuit or within a same device. In some examples, the various components within the de-warp processor can be realized in discrete or integrated component form, with an ultimate structure therefore being an application-specific or design selection. As the illustrated embodiments of the present invention may, for the most part, be implemented using electronic components and circuits known to those skilled in the art, details will not be explained in any greater extent than that considered necessary as illustrated below, for the understanding and appreciation of the underlying concepts of the present invention and in order not to obfuscate or distract from the teachings of the present invention. A skilled artisan will appreciate that the level of integration of processor circuits or components may be, in some instances, implementation-dependent.

Also, for example, the examples, or portions thereof, may implemented as soft or code representations of physical circuitry or of logical representations convertible into physical circuitry, such as in a hardware description language of any appropriate type. Also, the invention is not limited to physical devices or units implemented in non-programmable hardware but can also be applied in programmable devices or units able to perform the desired sampling error and compensation by operating in accordance with suitable program code, such as minicomputers, personal computers, notepads, personal digital assistants, electronic games, automotive and other embedded systems, cell phones and various other wireless devices, commonly denoted in this application as 'computer systems'. However, other modifications, variations and alternatives are also possible. The specifications and drawings are, accordingly, to be regarded in an illustrative rather than in a restrictive sense.

In the claims, any reference signs placed between parentheses shall not be construed as limiting the claim. The word 'comprising' does not exclude the presence of other elements or steps then those listed in a claim. Furthermore, the terms 'a' or 'an,' as used herein, are defined as one or more than one. Also, the use of introductory phrases such as 'at least one' and 'one or more' in the claims should not be construed to imply that the introduction of another claim element by the indefinite articles 'a' or 'an' limits any particular claim containing such introduced claim element to inventions containing only one such element, even when the same claim includes the introductory phrases 'one or more' or 'at least one' and indefinite articles such as 'a' or 'an.' The same holds true for the use of definite articles. Unless stated otherwise, terms such as 'first' and 'second' are used to arbitrarily distinguish between the elements such terms describe. Thus, these terms are not necessarily intended to indicate temporal or other prioritization of such elements. The mere fact that certain measures are recited in mutually different claims does not indicate that a combination of these measures cannot be used to advantage.

**Claims**

1. A memory (300) comprising a multi stage clock-partitioning circuit, the memory (300) comprising at least:

   at least one upper bitcell memory array (350, 352);
   at least one lower bitcell memory array (354, 356);
   an input configured to receive an external clock signal;
   a first stage (210) of the multi stage clock-partitioning circuit configured to receive the external clock signal and generate a first internal clock signal and provide the first internal clock signal to the upper bitcell memory array (350, 352) and the lower bitcell memory array (354, 356);
   a second stage (220) of the multi stage clock-partitioning circuit configured to receive the first internal clock signal and generate a second internal clock signal; and
   a third stage (230) of the multi stage clock-partitioning circuit configured to receive the second internal clock signal and generate a third word line generated clock signal and provide the third word line generated clock signal to the at least one upper bitcell memory array (350, 352) and the at least one lower bitcell memory array (354, 356).

2. The memory (300) of claim 1, wherein the memory (300) comprises a central portion (305) comprising the multi stage clock-partitioning circuit and wherein the at least one upper bitcell memory array (350, 352) and the at least one lower bitcell memory array (354, 356) both comprise a bitcell memory array located on a first side (350, 354) of the memory (300) and located on a second side (352, 356) of the memory (300).

3. The memory (300) of claim 2, wherein the memory (300) further comprises at least two first internal clock buffer circuits (310, 311) located in the central portion, wherein a first first internal clock buffer circuit (310) is located adjacent the upper bitcell memory array (350, 352) and a second first internal clock buffer circuit (310) is located adjacent the lower bitcell memory array (354, 356).

4. The memory (300) of claim 3, wherein the first first internal clock buffer circuit (310) and the second first internal clock buffer circuit (310) are located equidistant from the input.

5. The memory (300) of any of preceding claims 2 to 5, wherein the memory (300) further comprises at least four second internal clock generation circuits (320, 321, 322, 323) located in the central portion, wherein a first second internal clock generation circuit (320) is located adjacent an upper portion of the upper bitcell memory array (350, 352), a second second internal clock generation circuit (321) is located adjacent a lower portion of the upper bitcell memory array (350, 352), a third second internal clock generation circuit (322) is located adjacent an upper portion of the lower bitcell memory array (354, 356) and a fourth second internal clock generation circuit (323) is located adjacent a lower portion of the lower bitcell memory array (354, 356).

6. The memory (300) of claim 5, wherein:

   the first second internal clock generation circuit (320) and the fourth second internal clock generation circuit (323) are located equidistant from the input; and
   the second second internal clock generation circuit (321) and the third second internal clock generation circuit (322) are located equidistant from the input.

7. The memory (300) of any of preceding claims 2 to 6, wherein the memory (300) further comprises at least eight third internal clock generation circuits (330) located in the central portion, wherein:

   a first third internal clock generation circuit (330) is located adjacent an upper, upper portion of the upper bitcell memory array (350, 352),
   a second third internal clock generation circuit (330) is located adjacent a lower, upper portion of the upper bitcell memory array (350, 352),
   a third third internal clock generation circuit (330) is located adjacent an upper, lower portion of the upper bitcell memory array (350, 352),
   a fourth third internal clock generation circuit (330) is located adjacent a lower, lower portion of the upper bitcell memory array (350, 352),
   a fifth third internal clock generation circuit (330) is located adjacent an upper, upper portion of the lower bitcell memory array (354, 356),
   a sixth third internal clock generation circuit (330) is located adjacent a lower, upper portion of the lower bitcell memory array (354, 356),
   a seventh third internal clock generation circuit (330) is located adjacent an upper, lower portion of the lower bitcell memory array (354, 356),
   an eighth third internal clock generation circuit (330) is located adjacent a lower, lower portion of the lower bitcell memory array (354, 356).

8. The memory (300) of claim 7, wherein:

   the first third internal clock generation circuit (330) and the eighth third internal clock generation circuit (330) are located equidistant from the input;

the second third internal clock generation circuit (330) and the seventh third internal clock generation circuit (330) are located equidistant from the input;

the third third internal clock generation circuit (330) and the sixth third internal clock generation circuit (330) are located equidistant from the input; and

the fourth third internal clock generation circuit (330) and the fifth third internal clock generation circuit (330) are located equidistant from the input.

9. The memory (300) of any preceding claim wherein the first stage comprises a memory selection circuit (210), the second stage comprises a memory bank clock decoding circuit (220) and the third stage comprises a word line decoding circuit (230).

10. The memory (300) of any preceding claim, wherein the memory is one of: a static random access memory, SRAM, a read only memory, ROM.

11. A method (700) of constructing a memory (300) comprising a multi stage clock-partitioning circuit, the memory (300) comprising at least at least one upper bitcell memory array (350, 352) and at least one lower bitcell memory array (354, 356), wherein the method comprises:

receiving (710) an external clock signal;
generating (720) in a first stage (210) of the multi stage clock-partitioning circuit, a first internal clock signal from the external clock signal and providing the first internal clock signal to the upper bitcell memory array (350, 352) and the lower bitcell memory array (354, 356);
generating (730), in a second stage (220) of the multi stage clock-partitioning circuit, a second internal clock signal from the first internal clock signal;
generating (740), in a third stage (230) of the multi stage clock-partitioning circuit, a third word line generated clock signal from the second internal clock signal; and
providing (750) the third word line generated clock signal to the at least one upper bitcell memory array (350, 352) and the at least one lower bitcell memory array (354, 356).

100

150

110

115

120

125

130

135

140

Gio and write driver and
write assist circuitry

FIG. 1 – Prior Art

**FIG. 2**

**FIG. 3**

405    400

460

450

Bitcell Array
Right Upper

460    440    462

454    472
       1st Internal clock

Bitcell Array Right
Lower    474
         1st clock buffered

476
2nd internal clock

478
3rd internal clock

480
4th internal clock

464

462

452

Bitcell Array
Left Upper

456

Bitcell Array
Left Lower

466

**FIG. 4**

**FIG. 5**

| | | Clock buffering | | 2-Stage Clock partitioning | | Proposed Scheme | |
|---|---|---|---|---|---|---|---|
| Performance | | -- | | -- | | + | |
| | | | | | | | |
| Energy | | -- | | - | | + | |
| Area | | -- | | + | | + | |

**FIG. 6**

700

710

receiving an external clock signal

720

generating in a first stage of the multi-stage clock-partitioning circuit, a first internal clock signal from the external clock signal and providing the first internal clock signal to the upper bitcell array and the lower bitcell memory array

730

generating, in a second stage of the multi-stage clock-partitioning circuit, a second internal clock signal from the first internal clock signal

740

generating, in a third stage of the multi-stage clock-partitioning circuit, a third internal clock signal from the second internal clock signal

750

providing the third internal clock signal to the at least one upper bitcell array and the at least one lower bitcell memory array

**FIG. 7**

Europäisches
Patentamt
European
Patent Office
Office européen
des brevets

## EUROPEAN SEARCH REPORT

**Application Number**

EP 24 18 3088

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 898 636 A (ISOMURA SATORU [JP] ET AL) 27 April 1999 (1999-04-27) | 1-11 | INV. |
| Y | * column 4, line 61 - column 5, line 62 * | 1-11 | G11C5/02 |
| | * column 9, line 1 - column 10, line 2 * | | G11C5/06 |
| | * column 10, line 31 - column 11, line 37 * | | G11C7/22 |
| | * column 11, line 42 - column 12, line 31 * | | G11C11/417 |
| | * column 13, line 37 - column 14, line 41 * | | |
| | * figures 3, 11, 14-16, 18A * | | |
| | ----- | | |
| Y | US 2004/169535 A1 (MIZUNO HIROYUKI [JP]) 2 September 2004 (2004-09-02) * paragraphs [0048] - [0050], [0064] - [0069]; figures 4, 7, 10 * | 1-11 | |
| | ----- | | |
| A | US 5 512 766 A (KUSUNOKI MITSUGU [JP] ET AL) 30 April 1996 (1996-04-30) * column 5, lines 18-61 * * column 9, line 34 - column 10, line 11 * * column 19, line 41 - column 21, line 28 * * figures 1, 9, 18, 19 * | 1-11 | TECHNICAL FIELDS SEARCHED (IPC)<br><br>G11C |
| | ----- | | |

The present search report has been drawn up for all claims

| Place of search | Date of completion of the search | Examiner |
|---|---|---|
| The Hague | 5 November 2024 | Vidal Verdú, Jorge |

EPO FORM 1503 03.82 (P04C01)

## ANNEX TO THE EUROPEAN SEARCH REPORT
## ON EUROPEAN PATENT APPLICATION NO.

EP 24 18 3088

This annex lists the patent family members relating to the patent documents cited in the above-mentioned European search report.
The members are as contained in the European Patent Office EDP file on
The European Patent Office is in no way liable for these particulars which are merely given for the purpose of information.

05-11-2024

| Patent document cited in search report | | Publication date | Patent family member(s) | | Publication date |
|---|---|---|---|---|---|
| US 5898636 | A | 27-04-1999 | KR | 100361226 B1 | 23-11-2002 |
| | | | KR | 100364901 B1 | 20-12-2002 |
| | | | KR | 950002050 A | 04-01-1995 |
| | | | US | 5898636 A | 27-04-1999 |
| | | | US | 6034912 A | 07-03-2000 |
| US 2004169535 | A1 | 02-09-2004 | JP | 3753355 B2 | 08-03-2006 |
| | | | JP | 2000151369 A | 30-05-2000 |
| | | | KR | 20000035108 A | 26-06-2000 |
| | | | TW | 452680 B | 01-09-2001 |
| | | | US | 6396323 B1 | 28-05-2002 |
| | | | US | 2002105367 A1 | 08-08-2002 |
| | | | US | 2004169535 A1 | 02-09-2004 |
| | | | US | 2005075855 A1 | 07-04-2005 |
| US 5512766 | A | 30-04-1996 | JP | 3299260 B2 | 08-07-2002 |
| | | | JP | H04147663 A | 21-05-1992 |
| | | | KR | 920008745 A | 28-05-1992 |
| | | | US | 5512766 A | 30-04-1996 |

EPO FORM P0459

For more details about this annex : see Official Journal of the European Patent Office, No. 12/82